Europäisches Patentamt

European Patent Office

Office européen des brevets

(11) Numéro de publication: **0 274 073 B1**

(12) **FASCICULE DE BREVET EUROPEEN**

(19)

(51) Int. Cl.⁵: **H03D 9/06**, H01P 5/20

(45) Date de publication de fascicule du brevet: **20.05.92**

(21) Numéro de dépôt: **87118253.1**

(22) Date de dépôt: **09.12.87**

(54) **Dispositif mélangeur doublement équilibré.**

(30) Priorité: **11.12.86 FR 8617359**

(43) Date de publication de la demande:
**13.07.88 Bulletin 88/28**

(45) Mention de la délivrance du brevet:
**20.05.92 Bulletin 92/21**

(84) Etats contractants désignés:
**DE FR GB IT SE**

(56) Documents cités:

**PATENT ABSTRACTS OF JAPAN, vol. 10, no. 8 (E-373)[2065], 14 janvier 1986; & JP-A-60 172 803 (NIPPON DENSHIN DENWA KOSHA) 06-09-1985**

**PATENT ABSTRACTS OF JAPAN, vol. 4, no. 67 (E-11)[549], 20 mai 1980; & JP-A-55 35 530 (NIPPON DENSHIN DENWA KOSHA) 12-03-1980**

IEEE 1985 MICROWAVE AND MILLIMETER-WAVE MONOLITHIC CIRCUITS SYMPOSIUM DIGEST OF PAPERS, éditor M. COHN, pages 71-73, IEEE Microwave Theory and Techniques Society etc.; L.T. YUAN et al.: "A W-band monolithic balanced mixer"

(73) Titulaire: **ALCATEL ESPACE**
**11, avenue Dubonnet**
**F-92407 Courbevoie Cédex(FR)**

(72) Inventeur: **Goutoule, Jean Marc**
**4 Chemin de Peyrette**
**F-31170 Tournefeuille(FR)**

(74) Mandataire: **Weinmiller, Jürgen et al**
**Lennéstrasse 9 Postfach 24**
**W-8133 Feldafing(DE)**

**Description**

La présente invention concerne un dispositif mélangeur doublement équilibré.

De manière générale, les dispositifs mélangeurs permettent, à partir d'un premier signal de fréquence donnée, l'obtention par battement avec un deuxième signal de fréquence différente, délivré par un oscillateur local, d'un certain nombre de signaux de fréquences différentes, en particulier d'un signal à fréquence intermédiaire égale à la différence des deux fréquences précitées.

Un mélangeur doublement équilibré permet, à l'aide de coupleurs et déphaseurs, d'avoir une isolation naturelle entre les portes signal, oscillateur local et fréquence intermédiaire. De plus, de nombreuses combinaisons de fréquences parasites sont fortement atténuées vers la porte fréquence intermédiaire.

Les dispositifs connus de l'art antérieur présentent une limitation importante de largeur de bande de fréquence sur un des accès, généralement sur l'accès fréquence intermédiaire.

Les différentes portes sont chargées par des éléments parasites dimensionnés par les autres portes. Les circuits d'adaptation ne sont pas indépendants, ce qui interdit certains recouvrements entre les différentes bandes.

De plus, les dispositifs de l'art connu nécessitent un usinage particulier du substrat du circuit.

Ainsi un article intitulé "A 26 GHz Band integrated circuit of a double-balanced mixer and circulators" de Hiroyo Ogawa, Masami Akaike, Masayoski Aikawa, Toshisoh Karaki et et Junji Wakanabe paru dans "IEEE Transaction on microwave theory and techniques" (vol. MTT 30, n° 1, janvier 1982) décrit l'intégration d'un mélangeur doublement équilibré et d'un disque ferrite du type circulateur réalisée dans la bande des 26 GHz. Ce mélangeur est composé de lignes microstrip disposées sur une face du substrat, et de lignes à fente, de lignes couplées et de lignes coplanaires disposées sur l'autre face de ce substrat, deux fils permettant de connecter les lignes à fente aux lignes coplanaires.

L'objet de la présente invention est de pallier ces inconvénients.

Un article paru dans "IEEE Microwave and millimeter-wave monolithic circuits symposium digest of papers" de L.T. Yuan et Al intitulé "A W-band monolithic balanced mixer" (editor M. Colin ; pages 71-73 ; IEEE Microwave Theory and Techniques society) décrit un dispositif mélangeur équilibré dans lequel des mélangeurs élémentaires sont disposés à la jonction d'un té magique formé de ligne à fente et ligne coplanaire sur un support diélectrique (GaAs).

L'invention propose à cet effet un dispositif mélangeur doublement équilibré comprenant quatre mélangeurs élémentaires et trois accès, caractérisé en ce que des déphaseurs, permettant de réaliser un déphasage de $\pi + K\pi$, (K étant un nombre entier), sont respectivement disposés entre le premier mélangeur et le premier et le troisième accès; entre le deuxième mélangeur et le deuxième et le troisième accès; entre le troisième mélangeur et le premier accès; et entre le quatrième mélangeur et le deuxième accès, et en ce qu'il comprend un support diélectrique sur la face supérieure duquel sont disposés lesdits mélangeurs élémentaires ainsi que des films conducteurs, sous forme de lignes à fentes qui propagent un mode antisymétrique, ou de lignes coplanaires, qui propagent un mode symétrique et un mode antisymétrique; la combinaison de ces deux types de lignes et de leurs divers modes de propagation permettant de réaliser lesdits déphaseurs.

L'invention permet ainsi d'éviter les usinages particuliers du substrat qui sont dûs à l'utilisation des deux faces de celui-ci, et de présenter de très larges bandes sur les trois accès : par exemple, deux octaves de fréquence arbitrairement choisis dans la bande 2-26 GHz, pour le signal et la fréquence intermédiaire, et 1-26 GHz pour l'oscillateur local.

Les caractéristiques et avantages de l'invention ressortiront d'ailleurs de la description qui va suivre, à titre d'exemple non limitatif, en référence aux figures annexées sur lesquelles :
- la figure 1 représente une vue schématique du dispositif de l'invention.
- les figures 2 et 3 représentent des vues en perspective de deux réalisations du dispositif de l'invention.

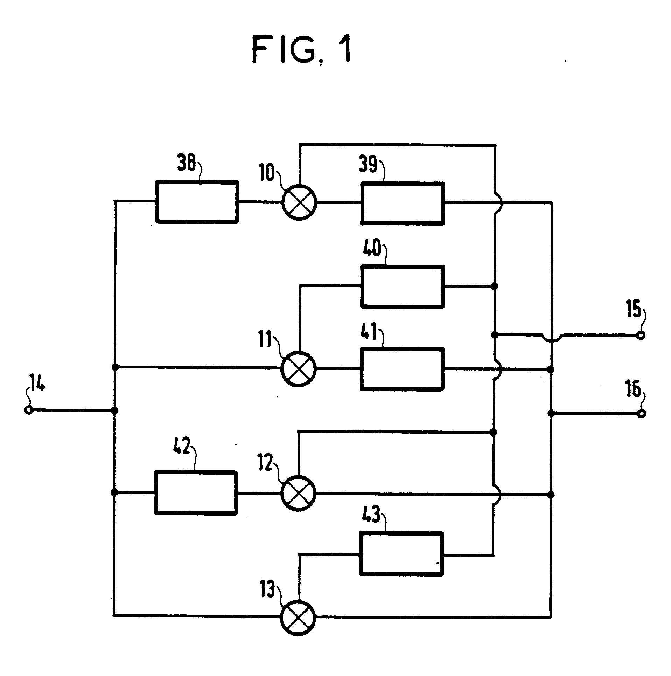

Sur la vue schématique de la figure 1, quatre mélangeurs élémentaires 10, 11, 12 et 13, par exemple des diodes, sont connectées à trois accès 14, 15 et 16. Des différences de phase $\pi$, disposées dans ces connections, sont réalisées au moyens de déphaseurs 38, 39, 40, 41, 42 et 43; Elles sont indiquées à $K\pi$ près (K entier).

La valeur angulaire $\pi$ n'est pas limitative; elle peut en effet, être entachée d'erreur.

Ces déphaseurs sont respectivement disposés entre le premier mélangeur (10) et le premier (14) et le troisième (16) accès (38 et 39); entre le deuxième mélangeur (11) et le deuxième (15) et le troisième (16) accès (40 et 41); entre le troisième mélangeur (12) et le premier (14) accès (42); et entre le quatrième mélangeur (13) et le deuxième accès (43). On définit ainsi des conditions de phase pour les trois signaux :
- fréquence radio (ou FR) ;
- fréquence intermédiaire (ou FI) ;

- oscillateur local (ou OL) ;

correspondant respectivement aux trois accès 14, 15 et 16.

Les oppositions de phase ainsi définies permettent d'obtenir la suppression de certaines raies, et d'affaiblir, ainsi, les fréquences parasites en sortie.

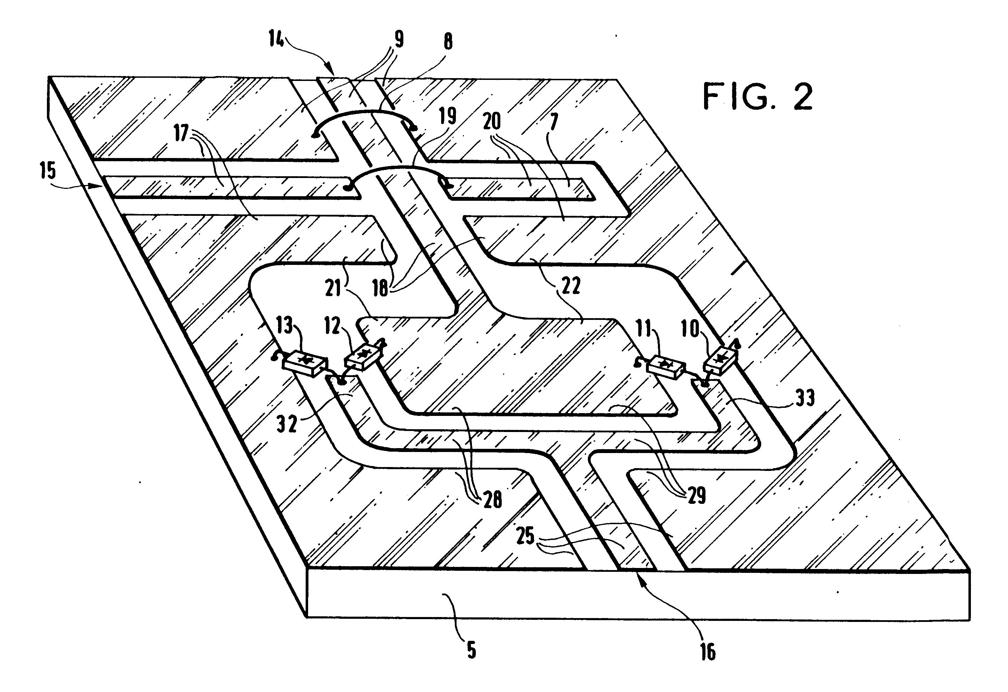

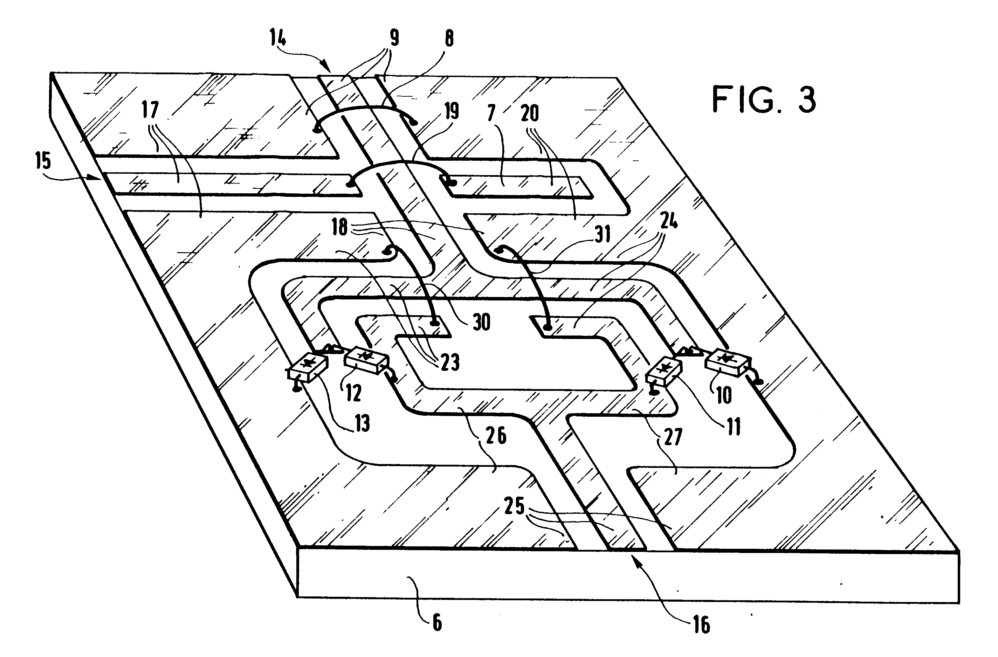

Les deux réalisations des figures 2 et 3, selon l'invention, utilisent deux supports diélectriques, ou substrate 5 et 6 sur la face supérieure desquels sont déposés des films conducteurs minces ou épais, sous forme de lignes à fente et de lignes coplanaires. Une ligne à fente propage un mode antisymétrique ; une ligne coplanaire, un mode symétrique et un mode antisymérique. Dans un mode symétrique, le champ électrique transversal est symétrique par rapport à l'axe de propagation.

Dans les deux réalisations représentées la combinaison de ces deux types de lignes et de leurs divers modes de propagation permet de réaliser les déphasages de la figure 1 sur les mélangeurs élémentaires 10, 11, 12, 13.

Dans les deux cas, l'accès 14 excite une ligne coplanaire 9 en mode symétrique et l'accès 15 excite une ligne coplanaire 17 en mode symétrique, qui excite une ligne coplanaire 18, située dans le prolongement de la ligne 9, en mode antisymétrique.

Un ruban métallique 8, qui forme un court-circuit pour le mode antisymétrique, permet le renvoi de toute l'énergie de la ligne 17 vers la ligne 18.

Pour une meilleure adaptation, une transition entre les lignes 17 et 18 est effectuée à l'aide d'un ruban métallique 19 et d'un ligne coplanaire en λ /4 20, le ruban 19 effectuant la liaison avec le conducteur central 7 de la ligne 20.

Sur la figure 2, la ligne coplanaire 18 se divise en deux lignes à fente 21 et 22.

Sur la figure 3, cette ligne 18 se divise en deux lignes coplanaires en mode symétrique 23 et 24. Deux rubans métalliques 30 et 31, réalisant des courts-circuits entre les deux parties latérales de ces lignes coplanaires 23 et 24, permettent de ne laisser passer qu'un mode symétrique dans chacune de ces deux lignes.

Les différentes lignes ainsi décrites c'est-à-dire les lignes 9, 17, 18, 21 et 22 et les lignes 9, 17, 18, 23 et 24 forment respectivement deux structures hybrides.

Sur la figure 2, les conducteurs latéraux des lignes 21 et 22 sont connectés aux diodes 10, 11, 12 et 13.

L'accès 16 excite une ligne coplanaire 25 en mode symétrique qui se partage en deux lignes coplanaires 28 et 29 à propagation symétrique dont les conducteurs centraux 32 et 33 sont respectivement connectés au points communs des diodes 12 et 13 et 10 et 11. Les deux premières diodes 10 et 11 sont disposées dans le sens passant des conducteurs latéraux vers le conducteur central 33 ; Les deux autres diodes 12 et 13 dans l'autre sens.

Sur la figure 3, l'accès 16 excite une même ligne coplanaire 25 en mode symétrique qui se partage, cette fois, en deux lignes à fentes 26 et 27 dont les conducteurs latéraux sont reliés aux diodes 12, 13, 10 et 11. Ces diodes ont toutes le même sens passant.

Les diodes 10, 11, 12, 13, ou mélangeurs élémentaires, sont fixées à la surface du substrat, par exemple par soudure, collage...

Dans le cas où les déphasages indiqués en figure 1 sont parfaits, l'isolation entre les trois accès est infinie, sinon l'isolation n'est pas infinie.

Il est bien entendu que la présente invention n'a été décrite et représentée qu'à titre d'exemple préférentiel et que l'on pourra remplacer ses éléments constitutifs par des éléments équivalents sans, pour autant, partir du cadre de l'invention.

Ainsi, les accès Signal (RF), fréquence intermédiaire (FI) et oscillateur local (OL) peuvent être permutés, le sens de montage des diodes peut être changé.

Ainsi la fréquence FI peut être une combinaison d'un harmonique de la fréquence OL et de la fréquence RF ou de la fréquence OL et de la fréquence RF.

Les mélangeurs élémentaires peuvent être reliés par des capacités, des selfs, ou des lignes couplées aux conducteurs environnants et peuvent être polarisées en courant continu. Des plages de conducteurs peuvent être isolées, en courant continu, des conducteurs environnants.

Des surfaces conductrices peuvent être supprimés.

## Revendications

1. Dispositif mélangeur doublement équilibré comprenant quatre mélangeurs élémentaires (10, 11, 12, 13) et trois accès (14, 15, 16), caractérisé en ce que des déphaseurs permettant de réaliser un déphasage de $\pi$ + K $\pi$ (K étant un nombre entier), sont respectivement disposés entre le premier mélangeur (10) et le premier (14) et le troisième accès (16); entre le deuxième mélangeur (11) et le deuxième (15) et le troisième (16) accès; entre le troisième mélangeur (12) et le premier accès (14); et entre le quatrième mélangeur (13) et le deuxième accès (15), et en ce qu'il comprend un support diélectrique (5, 6) sur la face supérieure duquel sont disposés lesdits mélangeurs élémentaires ainsi que des films conducteurs, sous forme de lignes à fentes qui propagent un mode antisymétrique, ou de lignes coplanaires, qui propagent un mode symétrique et un mode antisymétrique; la combinaison de ces deux types de lignes et de leurs divers modes de propagation permettant de réaliser lesdits déphaseurs.

2. Dispositif selon la revendication 1, caractérisé en ce que le premier accès (14) correspond au signal fréquence radio, le deuxième accès (15) correspond au signal fréquence intermédiaire et le troisième accès (16) correspond à l'oscillateur local.

3. Dispositif selon l'une des revendications 1 ou 2, caractérisé en ce que les trois accès (14, 15, 16) excitent des lignes coplanaires (9, 17, 25), les deux premières (9, 17) excitant une ligne coplanaire (18), respectivement en mode symétrique et antisymétrique, qui se partage en deux lignes connectées aux mélangeurs élémentaires (10, 11, 12, 13) un élément conducteur (8) reliant les deux conducteurs latéraux de la ligne coplanaire (9) excité par le premier accès (14).

4. Dispositif selon la revendication 3, caractérisé en ce que la ligne coplanaire (18) se partage en deux lignes à fentes (21, 22).

5. Dispositif selon la revendication 4, caractérisé en ce que le troisième accès (16) excite une ligne coplanaire (25) en mode symétrique qui se partage en deux lignes coplanaires (28 et 29) connectées aux mélangeurs élémentaires.

6. Dispositif selon la revendication 3, caractérisé en ce que la ligne coplanaire (18) se partage en deux lignes coplanaires (23, 24), deux éléments conducteurs (30, 31) reliant les conducteurs latéraux de ces lignes (23, 24).

7. Dispositif selon la revendication 6, caractérisé en ce que le troisième accès (16) excite une ligne coplanaire (25) qui se partage en deux lignes à fentes (26, 27) connectées aux mélangeurs élémentaires.

8. Dispositif selon l'une quelconque des revendications 3 à 7, caractérisé ence qu'un élément conducteur (19) relie le conducteur central de la ligne (17) issue du deuxième accès (15) au conducteur central (7) d'une ligne coplanaire (20) en λ/4 située symétriquement à cette ligne (17) par rapport à la ligne (9) issue du premier accès (14).

9. Dispositif selon l'une quelconque des revendications précédentes, caractérisé en ce que les mélangeurs élémentaires (10, 11, 12, 13) sont des diodes.

10. Dispositif selon l'une quelconque des revendications précédentes, caractérisé en ce que les éléments conducteurs sont des rubans métalliques.

**Claims**

1. Double balanced mixer device comprising four component mixers (10, 11, 12, 13) and three ports (14, 15, 16), characterised in that phase-shifters producing a phase-shift of $\pi + K\pi$ where K is an integer number are respectively disposed between the first mixer (10) and the first (14) and third (16) ports; between the second mixer (11) and the second (15) and third (16) ports; between the third mixer (12) and the first port (14); and between the fourth mixer (13) and the second port (15), and in that it comprises a dielectric support (5, 6) on the upper face of which are disposed said component mixers and conductive films forming slot lines which propagate an antisymmetric mode or coplanar lines which propagate a symmetric mode and an antisymmetric mode, the combination of these two types of lines and their various propagation modes providing said phase-shifters.

2. Device according to claim 1 characterised in that the first port (14) carries a radio frequency signal, the second port (15) carries an intermediate frequency signal and the third port (16) is connected to the local oscillator.

3. Device according to claim 1 or claim 2 characterised in that the three ports (14, 15, 16) drive coplanar lines (9, 17, 25), the first two (9, 17) drive a coplanar line (18) respectively in symmetric mode and antisymmetric mode which is divided into two lines connected to the component mixers (10, 11, 12, 13), a conductive member (8) connecting the two lateral conductors of the coplanar line (9) driven by the first port (14).

4. Device according to claim 3 characterised in that the coplanar line (18) is divided into two slot lines (21, 22).

5. Device according to claim 4 characterised in that the third port (16) drives a coplanar line (25) in symmetric mode which is divided into two coplanar lines (28 and 29) connected to the component mixers.

6. Device according to claim 3 characterised in that the coplanar line (18) is divided into two coplanar lines (23, 24), two conductive members (30, 31) connecting the lateral conductors of these lines (23, 24).

7. Device according to claim 6 characterised in that the third port (16) drives a coplanar line (25) which is divided into two slot lines (26, 27) connected to the component mixers.

8. Device according to any one of claims 3 through 7 characterised in that a conductive member (19) connects the central conductor of the line (17) from the second port (15) to the central conductor (7) of a λ/4 coplanar line (20) situated symmetrically to said line (17) relative to the line (9) from the first port (14).

9. Device according to any one of the preceding claims characterised in that the component mixers (10, 11, 12, 13) are diodes.

10. Device according to any one of the preceding claims characterised in that the conductive members are metal strips.

**Patentansprüche**

1. Doppelt abgeglichene Mischeinrichtung mit vier Elementarmischern (10, 11, 12, 13) und drei Anschlüssen, dadurch gekennzeichnet, daß je ein Phasenschieber zur Erzeugung einer Phasenverschiebung von π + Kπ (wobei K eine ganze Zahl ist) zwischen dem ersten Mischer (10) und dem ersten (14) und dritten Anschluß (16) bzw. zwischen dem Zweiten Mischer (11) und dem dritten Anschluß (16) bzw. zwischen dem dritten Mischer (12) und dem ersten Anschluß (14) bzw. zwischen dem vierten Mischer (13) und dem zweiten Anschluß (15) angeordnet ist, und daß die Mizcheinrichtung einen dielektrischen Träger (5, 6) aufweist, auf dessen oberer Fläche die Elementarmischer sowie leitende Schichten in Form von Schlitzleitungen, welche einen antisymmetrischen Wellentyp leiten, oder in Form von koplanaren Leitungen, welche einen symmetrischen und einen antisymmetrischen Wellentyp leiten, angeordnet sind, wobei die Kombination dieser beiden Leitungstypen und ihrer verschiedenen Wellenausbreitungstypen die Verwirklichung der genannten Phasenschieber ermöglichen.

2. Einrichtung nach Anspruch 1, dadurch gekennzeichnet, daß der erste Anschluß (14) dem Rundfunkfrequenzsignal, der zweite Anschluß (15) dem Zwischenfrequenzsignal und der dritte Anschluß (16) dem lokalen Oszillator entspricht.

3. Einrichtung nach Anspruch 1 oder 2, dadurch gekennzeichnet, daß die drei Anschlüsse (14, 15, 16) koplanare Leitungen (9, 17, 25) anregen, die beiden ersten Leitungen (9, 17) eine koplanare Leitung (18) im symmetrischen bzw. antisymmetrischen Modus erregen, die sich in zwei an die Elementarmischer (10, 11, 12, 13) angeschlossene Leitungen aufteilt, wobei ein leitendes Element (8) die beiden seitlichen Leiter der vom ersten Anschluß (14) erregten koplanaren Leitung (9) verbindet.

4. Einrichtung nach Anspruch 3, dadurch gekennzeichnet, daß sich die koplanare Leitung (18) in zwei Schlitzleitungen (21, 22) aufteilt.

5. Einrichtung nach Anspruch 4, dadurch gekennzeichnet, daß der dritte Anschluß (16) eine koplanare Leitung (25) im symmetrischen Modus erregt, die sich in zwei koplanare Leitungen (28 und 29) aufteilt, welche an die Elementarmischer angeschlossen sind.

6. Einrichtung nach Anspruch 3, dadurch gekennzeichnet, daß sich die koplanare Leitung (18) in zwei koplanare Leitungen (23, 24) aufteilt, wobei zwei leitende Elemente (30, 31) die seitlichen Leiter dieser Leitungen (23, 24) verbinden.

7. Einrichtung nach Anspruch 6, dadurch gekennzeichnet, daß der dritte Anschluß (16) eine koplanare Leitung (25) erregt, die sich in zwei Schlitzleitungen (26, 27) aufteilt, welche an die Elementarmischer angeschlossen sind.

8. Einrichtung nach einem beliebigen der Ansprüche 3 bis 7, dadurch gekennzeichnet, daß ein leitendes Element (19) den vom zweiten Anschluß (15) ausgehenden Mittelleiter der Leitung (17) mit dem Mittelleiter (7) einer koplanaren λ/4-Leitung verbindet, die relativ zu der vom ersten Anschluß (14) ausgehenden Leitung (9) symmetrisch zu dieser Leitung (17) liegt.

9. Einrichtung nach einem beliebigen der vorhergehenden Ansprüche, dadurch gekennzeichnet, daß die Elementarmischer (10, 11, 12, 13) Dioden sind.

10. Einrichtung nach einem beliebigen der vorhergehenden Ansprüche, dadurch gekennzeichnet, daß die leitenden Elemente Metallbänder sind.

FIG. 1

FIG. 2

FIG. 3

EP 0 274 073 B1